# EUROPÄISCHE PATENTSCHRIFT

(11) **EP 0 937 999 B1**
(45) Veröffentlichungstag und Bekanntmachung des Hinweises auf die Patenterteilung: **23.03.2005**
(21) Anmeldenummer: 99100940.8
(22) Anmeldetag: 20.01.1999
(51) Int. Cl.: G02B 5/30, G03F 7/20

(54) **Optisches System mit Polarisationskompensator**
Optical system with polarisation compensator
Système optique avec compensateur de polarisation

(30) Priorität: 20.02.1998 DE 19807120
(43) Veröffentlichungstag der Anmeldung: 25.08.1999
(73) Patentinhaber: Carl Zeiss SMT AG, 73447 Oberkochen (DE)
(72) Erfinder: Fürter, Gerhard, 73479 Ellwangen (DE); Kaiser, Winfried, 73431 Aalen (DE); Wagner, Christian Dr., 73431 Aalen (DE); Gerhard, Michael Dr., 73432 Aalen (DE); Schuster, Karl-Heinz, 89551 Königsbronn (DE)
(74) Vertreter: Müller-Rissmann, Werner Albrecht, Dr.

(56) Entgegenhaltungen:
- EP-A- 0 764 858
- DE-A- 19 637 563
- US-A- 3 663 087

## Beschreibung

In einem optischen System, das mit Licht definierter Polarisation - z.B. linear polarisiert - ausgeleuchtet wird, tritt eine lokal unterschiedliche Störung der Polarisation auf, verursacht unter anderem durch den von der Polarisationsrichtung abhängigen Reflexionsgrad an den geneigten optischen Grenzflächen und durch Spannungsdoppelbrechung in Linsen. Nach einem folgenden Analysator treten dann lokale Helligkeitsschwankungen auf.

Ein System, bei dem dieser Effekt von Bedeutung ist, sind die Projektionsbelichtungsanlagen der Mikrolithographie mit linear polarisiertem Excimer-Laser im DUV und katadioptrischem Reduktionsobjektiv mit Polarisationsstrahlteiler, wie z.B. aus der DE 196 16 922 (US Serial No. 08/845,384 vom 15.04.1997) bekannt.

Kompensatoren zur kontinuierlich veränderbaren Drehung einer Polarisationsrichtung sind bekannt, z.B. in Form des Soleil-Babinet-Kompensators, allerdings nur mit einheitlicher Wirkung für den ganzen Lichtbündelquerschnitt.

Phasenkorrekturplatten zur Wellenfrontkorrektur in Präzisionsoptiken z.B. durch Ionenstrahlätzen mit "Nanoasphären"-Feinstprofil bearbeitet, sind zum Einsatz in Mikrolithographie-Projektionsbelichtungsanlagen bekannt.

Doppelbrechende Kristalle von Magnesiumfluorid und von Quarz sind zur Herstellung polarisationsoptischer Elemente mit Transmission im tiefen Ultraviolett (DUV) bei z.B. 193 nm geeignet. Daneben sind auch Elemente mit Spannungsdoppelbrechung, z.B. nach DE 196 37 563, bekannt.

Aufgabe der Erfindung ist es, eine Anordnung anzugeben, mit der lokale Störungen des Polarisationszustandes von Licht in einem optischen System ausgeglichen werden können. Speziell sollen die durch Polarisationsstörungen bewirkten Störungen der Homogenität in optischen Systemen mit Polarisationsstrahlteiler, wie in katadioptrischen Reduktionsobjektiven vom oben angegebenen Typ, ausgeglichen werden. Dazu ist ein Herstellverfahren anzugeben.

Gelöst wird die Aufgabe durch ein optisches System nach Anspruch 1 mit mindestens einem doppelbrechenden Element mit unregelmäßig variierender Dicke als Polarisationskompensator. Vorteilhafte Weiterbildungen sind Gegenstand der Unteransprüche 2 bis 8.

Besonders vorzuziehen ist die Ausführung nach Anspruch 2, bei der paarweise doppelbrechende Elemente mit gegeneinander verdrehten (vorzugsweise um 45°) Hauptachsen vorgesehen sind. Damit können wirklich hinsichtlich der Orientierung beliebige Polarisationsstörungen ausgeglichen werden.

Ebenso optimiert die Anordnung von Kompensationsplatten aus isotropem Material nach Anspruch 3 die Korrektur.

Das erfindungsgemäße Herstellverfahren wird in Anspruch 8 angegeben, dazu in den Ansprüchen 9 und 10 vorteilhafte Ausführungsformen.

Näher erläutert wird die Erfindung anhand der Zeichnung.
- Figur 1: zeigt schematisch eine Projektionsbelichtungsanlage mit doppelbrechenden Polarisations-Korrekturelementen.
- Figur 2: zeigt schematisch zwei Polarisations-Korrekturelemente mit verschiedenen Hauptachsenrichtungen.

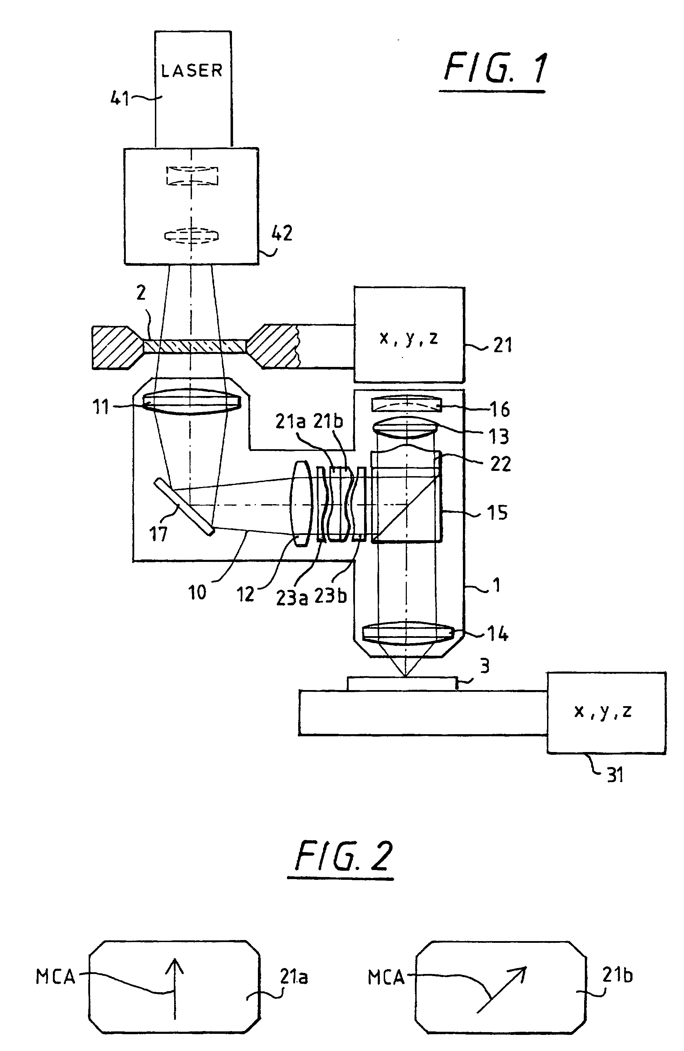

Kern der Projektionsbelichtungsanlage nach Figur 1 ist ein katadioptrisches Reduktionsobjektiv 1, welches eine Maske (Retikel) 2 auf einem Wafer 3 verkleinert abbildet. Maske 2 wie Wafer 3 sind an Halte- und Positioniersystemen 21, 31 angebracht, mit denen die genaue Positionierung und die Stepand-Repeat- bzw. Step-and-Scan-Abläufe durchgeführt werden.

Durch einen Laser 41, insbesondere einen linear polarisierten DUV-Excimer-Laser, mit nachgeordneter Beleuchtungs-Optik 42, wird die Maske 2 geeignet beleuchtet.

Das Reduktionsobjektiv 1 besteht zunächst in bekannter Weise aus Linsengruppen 11 bis 14, dem Polarisationsstrahlteilerwürfel 15, dem Umlenkspiegel 17, dem Konkavspiegel 16 und einer Lambdaviertelplatte 22.

Aus den verschiedensten Einflüssen (u. a. Spannungsdoppelbrechung) resultierend ergibt sich im Strahlengang eine Störung des Polarisationszustands mit über den Querschnitt lokal variierender Richtung und Größe. Damit wird die Strahlteilung am Polteiler inhomogen, das Bild wird gestört, wenn keine Gegenmaßnahmen ergriffen werden.

Erfindungsgemäß sind im Strahlengang 10 hinter den Linsengruppen 11, 12 doppelbrechende optische Elemente 21a, 21b (mindestens eines) vorgesehen, deren Dicke über den Querschnitt unregelmäßig ist, und welche die lokalen Störungen der linearen Polarisation im Strahlengang 10 kompensieren - zumindest teilweise -.

Zur optimalen Erfassung und Korrektur aller Polarisationsrichtungen sind zwei Elemente 21a, 21b erforderlich, deren Hauptachsen MCA gegeneinander verdreht sind, am besten um 45°, wie Fig. 2 zeigt.

Auch die Lambdaviertelplatte 22 ist im Beispiel derartig in ihrer Dicke korrigiert und kompensiert die im weiteren Strahlengang auftretenden Polarisationsfehler und ggf. Restfehler. Bei ihr ist zu beachten, daß sie vom Lichtbündel 10 zweimal durchlaufen wird.

Platten 23a, 23b aus isotropem Material (Quarzglas) weisen zu den Korrekturplatten 21a, 21b optisch negative Formen auf. Dadurch wird der optische Weg über dem ganzen Querschnitt des Lichtbündels 10 wieder gleich, so daß die Wellenfront durch die Kombination der Elemente 21a, 21b und Platten 23a, 23b nicht gestört wird.

Hergestellt werden können die Freiformflächen der Elemente 21a, 21b und der Platten 23a, 23b durch Ionenstrahl-Bearbeitung. Die Dickenmodulation der Elemente 21a, 21b bzw. Platten 23a, 23b bewegt sich dabei um Werte bis ca 3 µm.

Zur Vermeidung von Reflexionen an den Grenzflächen werden die Elemente 21a, 21b und Platten 23a, 23b untereinander und mit dem Strahlteilerwürfel 15 möglichst ohne Luftspalt vereinigt. Dies gelingt durch Ansprengen oder durch Verkitten, letzteres allerdings nicht im DUV-Wellenlängenbereich.

Aus dem gleichen Grund werden die Platten 23a, 23b aus isotropem Material vorzugsweise zu einem Element vereinigt einteilig ausgeführt.

Vorteilhaft sowohl von der Herstellung wie von der genauen Paßform und dem spaltfreien Fügen ist es, wenn die Platten 23a, 23b jedoch durch Beschichten der bearbeiteten Fläche der Polarisationskompensator-Elemente 21a, 21b mit isotropem Material - z.B. CVD-Abscheidung von Quarzglas - erzeugt werden, das zum Schluß optisch poliert wird. Die aus den unterschiedlichen Brechungsindices resultierende Reststörung der Wellenfront kann durch Ionen- oder Atomstrahl-Bearbeitung mit kleineren Höhendifferenzen noch korrigiert werden.

Die als Polarisations-Korrekturelement ausgebildete Lambdaviertelplatte 22 ist nur exemplarisch allein gestellt, auch hier ist die Kombination mit einem isotropen (amorphen) Kompensator und die bauliche Vereinigung mit benachbarten Elementen, insbesondere durch Ansprengen an den Strahlteilerwürfel 15, sinnvoll und vorteilhaft.

Die Form der Korrekturflächen der Elemente 21a, 21b, 22 und Platten 23a, 23b wird vorzugsweise für jedes Objektiv einzeln festgelegt. Dazu kann die Qualität von Testbelichtungen ausgewertet werden, oder es kann mit Rastersonden die lokale Polarisation bzw. die Wellenfront im Querschnitt des Lichtbündels 10 bestimmt werden.

## Patentansprüche

1. Optisches System mit mindestens einem optischen Element (2, 11, 12), das eine Störung der Polarisationsverteilung über den Querschnitt eines Lichtbündels (10) bewirkt, **dadurch gekennzeichnet, daß** mindestens ein doppelbrechendes optisches Element (22) vorgesehen ist mit über den Querschnitt unregelmäßig variierender Dicke, derart daß die Störung der Polarisationsverteilung Zumindest teilweise kompensiert wird.

2. Optisches System nach Anspruch 1, **dadurch gekennzeichnet, daß** mindestens zwei doppelbrechende optische Elemente (21a, 21b) mit variierender Dicke vorgesehen sind, deren Hauptachsen gegeneinander verdreht sind, vorzugsweise um 45°.

3. Optisches System nach Anspruch 1 oder 2, **dadurch gekennzeichnet, daß** mindestens eine Platte (23a, 23b) aus isotropem Material vorgesehen ist, mit über den Querschnitt variierender Dicke, derart daß Störungen der Wellenfront durch das doppelbrechende optische Element (21) ausgeglichen werden.

4. Optisches System nach Anspruch 3, **dadurch gekennzeichnet, daß** eine obengenannte Platte (23a, 23b) und ein obengenanntes doppelbrechendes optisches Element (21a, 21b) vereinigt sind.

5. Optisches System nach mindestens einem der Ansprüche 1-4, **dadurch gekennzeichnet, daß** ein Polarisationsstrahlteiler (15) enthalten ist.

6. Optisches System nach Anspruch 5, **dadurch gekennzeichnet, daß** ein besagtes doppelbrechendes optisches Element (21a, 21b, 22) und/oder eine obengenannte Platte (23a, 23b) mit dem Polarisationsstrahlteiler (15) baulich vereinigt ist.

7. Optisches System nach Anspruch 5 oder 6, **dadurch gekennzeichnet, daß** es ein katadioptrisches Objektiv (1) enthält, in dem der Polarisationsstrahlteiler (15) angeordnet ist, und daß ein besagtes doppelbrechendes optisches Element (21a, 21b) im Strahlengang vor dem Polarisationsstrahlteiler (15) angeordnet ist.

8. Optisches System nach mindestens einem der Ansprüche 5, 6 oder 7, **dadurch gekennzeichnet, daß** ein besagtes doppelbrechendes optisches Element (22) im vom Lichtbündel (10) doppelt durchlaufenen Weg zwischen Polarisationsstrahlteiler (15) und Konkavspiegel (16) angeordnet ist.

9. Verfahren zur Herstellung eines optischen Systems, **dadurch gekennzeichnet, daß** ein Teilsystem (11, 17, 12) fertig montiert und justiert wird, dieses zur Bestimmung einer Störung der Polarisationsverteilung polarisationsoptisch präzisionsvermessen wird, entsprechend den polarisationsoptischen Meßdaten mindestens ein doppelbrechendes optisches Element (21a, 21b, 22) lokal unterschiedlich abgetragen wird, vorzugsweise durch
Ionenstrahlbearbeitung, so daß die Dicke über den Querschnitt variiert, und dann dieses Element (21a, 21b, 22) in den Strahlengang (10) hinter dem genannten Teilsystem (11, 17, 12) eingebracht wird, um die Störung zumindest teilweise zu kompensieren.

10. Verfahren nach Anspruch 9, **dadurch gekennzeichnet, daß** ein zweites doppelbrechendes optisches Element (21b) mit gegenüber dem ersten (21a) verdrehter Hauptachse (MCA) ebenfalls lokal unterschiedlich abgetragen wird und in den Strahlengang (10) eingebracht wird.

11. Verfahren nach Anspruch 9 oder 10, **dadurch gekennzeichnet, daß** zusätzlich mindestens eine Wellenfrontkompensations-Platte (23a, 23b) aus isotropem Material hergestellt wird, mit zu den obengenannten Elementen (21a, 21b) optisch komplementärer Dickenverteilung über dem Querschnitt, und daß diese den obengenannten Elementen (21a, 21b) benachbart in den Strahlengang (10) eingebracht wird.

## Claims

1. Optical system having at least one optical element (2, 11, 12), which effects a disturbance in the polarization distribution over the cross section of a light bundle (10), **characterized in that** at least one birefringent optical element (22) is provided which has a thickness varying irregularly over the cross section in such a way that the disturbance of the polarization distribution is compensated at least partially.

2. Optical system according to Claim 1, **characterized in that** at least two birefringent optical elements (21a, 21b) of varying thickness are provided, whose main axes are rotated against one another by preferably 45°.

3. Optical system according to Claim 1 or 2, **characterized in that** provision is made of at least one plate (23a,23b) which is made from an isotropic material and has a thickness which varies over the cross section in such a way that disturbances in the wavefront are compensated by the birefringent optical element (21).

4. Optical system according to Claim 3, **characterized in that** an above-named plate (23a, 23b) and an above-named birefringent optical element (21a, 21b) are combined.

5. Optical system according to at least one of Claims 1-4, **characterized in that** a polarization beam splitter (15) is included.

6. Optical system according to Claim 5, **characterized in that** a said birefringent optical element (21a, 21b, 22) and/or an above-named plate (23a, 23b) is/are structurally combined with the polarization beam splitter (15).

7. Optical system according to Claim 5 or 6, **characterized in that** it includes a catadioptric objective (1) in which the polarization beam splitter (15) is arranged, and **in that** a said birefringent optical element (21a, 21b) is arranged in the beam path upstream of the polarization beam splitter (15).

8. Optical system according to at least one of Claims 5, 6 or 7, **characterized in that** a said birefringent optical element (22) is arranged in the path, traversed twice by the light bundle (10), between the polarization beam splitter (15) and concave mirror (16).

9. Method for producing an optical system, **characterized in that** a subsystem (11, 17, 12) is mounted and adjusted in a finished fashion and its polarization-optical properties are measured with precision to measure a disturbance of polarization distribution, at least one birefringent optical element (21a, 21b, 22) isablat, preferably by ion beam processing, in a locally differing fashion in accordance with the polarization-optical measured data, such that thickness varies on the cross section and then this element (21a, 21b, 22) is introduced into the beam path (10) downstream of the said subsystem (11, 17, 12), to at least partially compensate the disturbance.

10. Method according to Claim 9, **characterized in that** a second birefringent optical element (21b) with a main axis (MCA) rotated by comparison with the first one (21a) is removed, likewise in a locally differing fashion, and is introduced into the beam path (10).

11. Method according to Claim 9 or 10, **characterized in that** in addition at least one wavefront compensation plate (23a, 23b) made from isotropic material is produced, with a thickness distribution over the cross section which is optically complementary to the above-named elements (21a, 21b), and **in that** the said plate is introduced into the beam path (10) next to the above-named elements (21a, 21b).

## Revendications

1. Système optique comprenant au moins un élément optique (2, 11, 12) qui provoque une perturbation de la distribution de la polarisation sur la section transversale d'un faisceau lumineux (10), **caractérisé en ce qu'**il est prévu au moins un élément optique biréfringent (22) dont l'épaisseur varie de manière irrégulière sur la section transversale de manière à compenser au moins partiellement la perturbation de la distribution de la polarisation.

2. Système optique selon la revendication 1, **caractérisé en ce que** sont prévus au moins deux éléments optiques biréfringents (21a, 21b) dont l'épaisseur varie et dont les axes principaux sont pivotés l'un par rapport à l'autre, de préférence de 45°.

3. Système optique selon la revendication 1 ou 2, **caractérisé en ce qu'**il est prévu au moins une plaque (23a, 23b) en matériau isotrope dont l'épaisseur varie sur la section transversale de manière à ce que les perturbations du front d'onde soient compensées par l'élément optique biréfringent (21).

4. Système optique selon la revendication 3, **caractérisé en ce qu'**une plaque (23a, 23b) mentionnée ci-dessus et un élément optique biréfringent (21a, 21b) mentionné ci-dessus sont réunis.

5. Système optique selon au moins l'une des revendications 1 à 4, **caractérisé en ce qu'**il contient un diviseur de rayon à polarisation (15).

6. Système optique selon la revendication 5, **caractérisé en ce qu'**un dit élément optique biréfringent (21a, 21b, 22) et/ou une plaque (23a, 23b) mentionnée ci-dessus est réuni par construction avec le diviseur de rayon à polarisation (15).

7. Système optique selon la revendication 5 ou 6, **caractérisé en ce qu'**il contient un objectif catadioptrique (1) dans lequel est logé le diviseur de rayon à polarisation (15) et qu'un dit élément optique biréfringent (21a, 21b) est disposé dans le trajet du rayon avant le diviseur de rayon à polarisation (15).

8. Système optique selon au moins l'une des revendications 5, 6 ou 7, **caractérisé en ce qu'**un dit élément optique biréfringent (22) est disposé dans le trajet parcouru deux fois par le faisceau lumineux (10) entre le diviseur de rayon à polarisation (15) et un miroir concave (16).

9. Procédé de fabrication d'un système optique, **caractérisé en ce qu'**un système partiel (11, 17, 12) est monté et réglé, son optique de polarisation est mesurée avec précision pour mésurer une disturbance de la distribution de la polarization, au moins un élément optique biréfringent (21a, 21b, 22) est enlevé en différents endroits en fonction des caractéristiques de mesure optiques de la polarisation, de préférence par traitement par faisceau d'ions,de façon que l'epaisseur varie en section transversale et cet élément (21a, 21b, 22) est ensuite monté dans le trajet du faisceau (10) derrière ledit système partiel (11, 17, 12) pour compenser la disturbance au moins partiellement.

10. Procédé selon la revendication 9, **caractérisé en ce qu'**un deuxième élément optique biréfringent (21b) dont l'axe principal (MCA) est pivoté par rapport à celui du premier (21a) est lui aussi enlevé en différents endroits et monté dans le trajet du faisceau (10).

11. Procédé selon la revendication 9 ou 10, **caractérisé en ce qu'**au moins une plaque de compensation de front d'onde supplémentaire (23a, 23b) est fabriquée en matériau isotrope avec une distribution optique complémentaire de l'épaisseur sur la section transversale par rapport aux éléments (21a, 21b) mentionnés ci-dessus et que celle-ci est insérée dans le trajet du faisceau (10) à côté des éléments (21a, 21b) mentionnés ci-dessus.
